# EUROPEAN PATENT SPECIFICATION

(11) **EP 2 878 870 B1**
(45) Date of publication and mention of the grant of the patent: **15.06.2016**
(21) Application number: 13195024.8
(22) Date of filing: 29.11.2013
(51) Int. Cl.: F16K 51/02, F16K 31/163, F16K 3/02, H01L 21/67

(54) **Self-lockable opening and closing mechanism for vacuum cabin door**
Selbstverriegelnder Öffnungs- und Schließmechanismus für eine Vakuumkabinentür
Mécanisme d'ouverture et de fermeture autoverrouillable pour porte de cabine à vide

(43) Date of publication of application: 03.06.2015
(73) Proprietor: King Lai Hygienic Materials Co., Ltd., 30264 Zhubei City, Hsinchu County (TW)
(72) Inventor: Tsai, Huan-Yu, 30264 Zhubei City, Hsinchu County (TW)
(74) Representative: Viering, Jentschura & Partner mbB Patent- und Rechtsanwälte

(56) References cited:
- WO-A1-2013/123692
- US-A- 5 967 486

## Description

### BACKGROUND OF THE INVENTION

### 1. Field of the Invention:

The present invention relates to vacuum cabin door technology, and more particularly to a self-lockable opening and closing mechanism for vacuum cabin door, which automatically produces a locking force to lock the vacuum cabin door in position when the vacuum cabin door is closed.

### 2. Description of the Related Art:

In semiconductor industry involving wafer fabrication or TFT LCD production, glass substrates are normally processed in a vacuum environment, for example, in a vacuum cabin. A vacuum cabin generally comprises a vacuum cabin door drivable by an opening and closing mechanism between an open position and a close position. When the vacuum cabin door is opened, the workpiece can be moved over the vacuum cabin door into the inside of the vacuum cabin. After the workpiece is delivered into the inside of the vacuum cabin, the vacuum cabin door is closed, and then a pumping operation is performed to draw air out of the vacuum cabin.

An opening and closing mechanism for vacuum cabin is known using a pneumatic cylinder or hydraulic cylinder to move the vacuum cabin door between the open position and the close position either directly or through a rack and gear mechanism. However, when the vacuum cabin door is moved to the close position, the pneumatic or hydraulic cylinder must keep giving pressure to the vacuum cabin door panel against the cabin door frame, keeping the vacuum cabin door in the close position. However, after a long use of the machine, a wear problem may occur, and the pneumatic or hydraulic pressure of the pneumatic or hydraulic cylinder may become insufficient due to pipeline problems, resulting in sealing failure between the vacuum cabin door and the vacuum cabin.

Taiwan Patent TW430012 discloses a vacuum cabin door opening and closing mechanism, which comprises a frame, a first pneumatic cylinder affixed to the frame, a second pneumatic cylinder affixed to the first pneumatic cylinder and movable up and down relative to the first pneumatic cylinder, a vacuum cabin door, and a linkage coupled between the vacuum cabin door and the second pneumatic cylinder. During operation, the first pneumatic cylinder is driven to move the second pneumatic cylinder and the vacuum cabin door upwardly into alignment with the vacuum cabin, and then the second pneumatic cylinder is retracted, driving the linkage to move the vacuum cabin door horizontally toward the vacuum cabin, and thus the vacuum cabin is closed by the vacuum cabin door. According to this design, it is necessary to move the vacuum cabin door vertically and horizontally through two actions, prolonging the operation time and increasing the structural dimension and cost.

Further, CN 101787834 B discloses an opening and closing device for horizontal vacuum cabin, which has multiple auto locking mechanisms mounted at the outside wall around the opening of the vacuum cabin for locking the vacuum cabin door to the vacuum cabin in the close position. However, this design is not a perfect solution because the opening and closing device and the auto locking mechanism must be separately driven and controlled. WO 2013/123692 discloses a mechanism according to the preamble of claim 1.

### SUMMARY OF THE INVENTION

The present invention has been accomplished under the circumstances in view. It is the main object of the present invention to provide a self-lockable opening and closing mechanism for vacuum cabin door, which uses a driving cylinder to move a linkage mechanism in moving the vacuum cabin door between an open position and a close position, and automatically produces a locking force to hold the vacuum cabin door in the close position against any reaction force, preventing the problem of failure or reduced effect in vacuum sealing due to insufficient power.

To achieve this and other objects of the present invention, a self-lockable opening and closing mechanism of the present invention comprises a frame that is a hollow frame formed of a base portion, two side panels and a top panel, a driving cylinder mounted at the base portion within the frame and comprising a reciprocatable driving shaft, a horizontal lever fixedly connected to the driving shaft, at least one first bar each having one end thereof pivotally connected to the horizontal lever, at least one rotational lever each comprising a first pivot hole, a second pivot hole and a third pivot hole respectively located at three corners of a triangular profile thereof, the first pivot hole of each rotational lever being pivotally connected to an opposite end of one respective first bar, at least one adjustment block respectively pivotally connected to the second pivot hole of one respective rotational lever, at least one second bar each having one end thereof pivotally connected to the third pivot hole of one respective rotational lever, at least one sliding block respectively slidably mounted at one respective side panel within the frame and respectively pivotally connected to an opposite end of one respective second bar, a vacuum cabin door, and at least one valve rod each having one end thereof connected to one respective sliding block and an opposite end thereof connected to the vacuum cabin door for moving the vacuum cabin door between an open position and a close position.

Further, when the driving cylinder drives the vacuum cabin door to the close position, the imaginary axis extending through the second pivot hole and third pivot hole of each rotational lever and the axis of the respective second bar define a contained angle (θ) within the range of 170°∼190°. Preferably, the imaginary axis extending through the second pivot hole and third pivot hole of each rotational lever and the axis of the respective second bar are kept in axial alignment and in a parallel relationship with the axis of the driving cylinder when the driving cylinder drives the vacuum cabin door to the close position. Thus, if the door panel of the vacuum cabin door is forced by a reaction force or any other factor to move in the reverse direction at this time, the reaction force will be linearly transferred through the at least one valve rod, the at least one sliding block, the at least one second bar, the at least one rotational lever and the at least one adjustment block to the top panel of the frame, preventing the component parts and the vacuum cabin door from working and assuring positive locking of the vacuum cabin door. Thus, the invention does not need an extra power to keep the driving cylinder in the locking position.

Preferably, the self-lockable opening and closing mechanism further comprises a sliding guide means, for example, linear guideway located at each side panel and extending in a parallel manner relative to the axis of the driving shaft for guiding sliding movement of one respective sliding block along one respective side panel of the frame, enhancing sliding smoothness and displacement precision.

Preferably, the self-lockable opening and closing mechanism further comprises at least one adjustment screw rotatably mounted in the top panel of the frame and respectively threaded into one respective adjustment block in a parallel manner relative to the axis of the driving shaft and rotatable to adjust the distance between one respective adjustment block and the top panel of the frame.

### BRIEF DESCRIPTION OF THE DRAWINGS

Other and further advantages and features of the present invention will be understood by reference to the description of the preferred embodiment in conjunction with the accompanying drawings where the components are illustrated based on a proportion for explanation but not subject to the actual component proportion.
**FIG. 1** is a perspective view of a self-lockable opening and closing mechanism for vacuum cabin door in accordance with the present invention.
**FIG. 2** is an exploded view of the self-lockable opening and closing mechanism for vacuum cabin door in accordance with the present invention.
**FIG. 3** is an exploded view of the linkage mechanism of the self-lockable opening and closing mechanism for vacuum cabin door in accordance with the present invention.
**FIG. 4** is a schematic plain view of the present invention illustrating the self-lockable opening and closing mechanism in the open position.
**FIG. 5** is an enlarged view of a part of **FIG. 4****.**
**FIG. 6** is a schematic plain view of the present invention illustrating the self-lockable opening and closing mechanism in the close position.
**FIG. 7** is an enlarged view of a part of **FIG. 6****.**

### DETAILED DESCRIPTION OF THE INVENTION

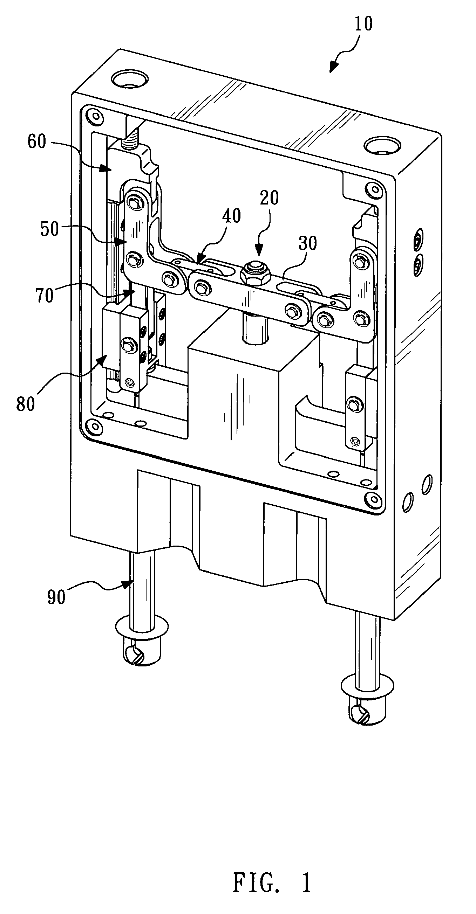

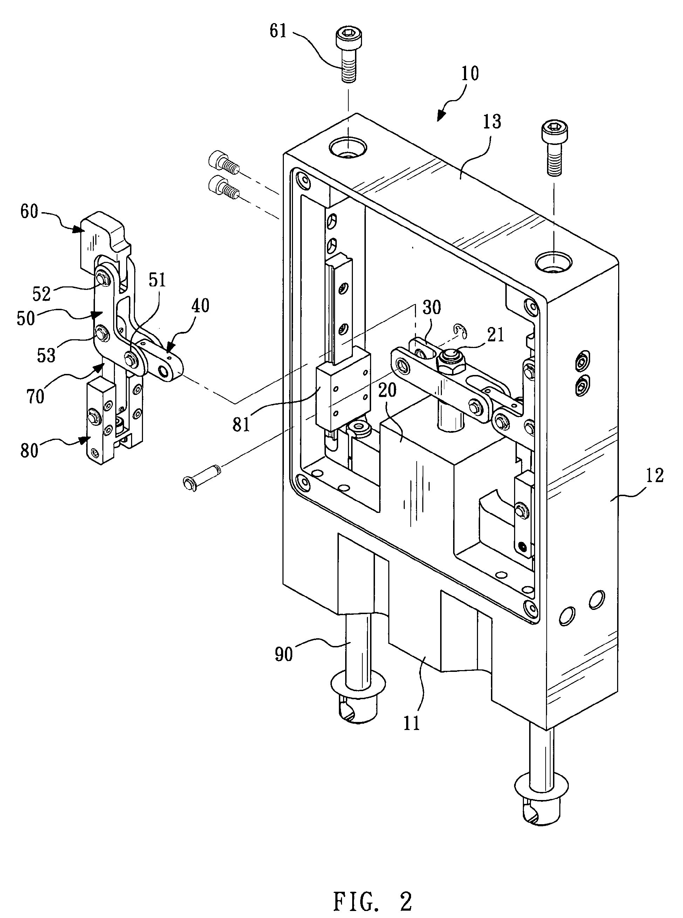

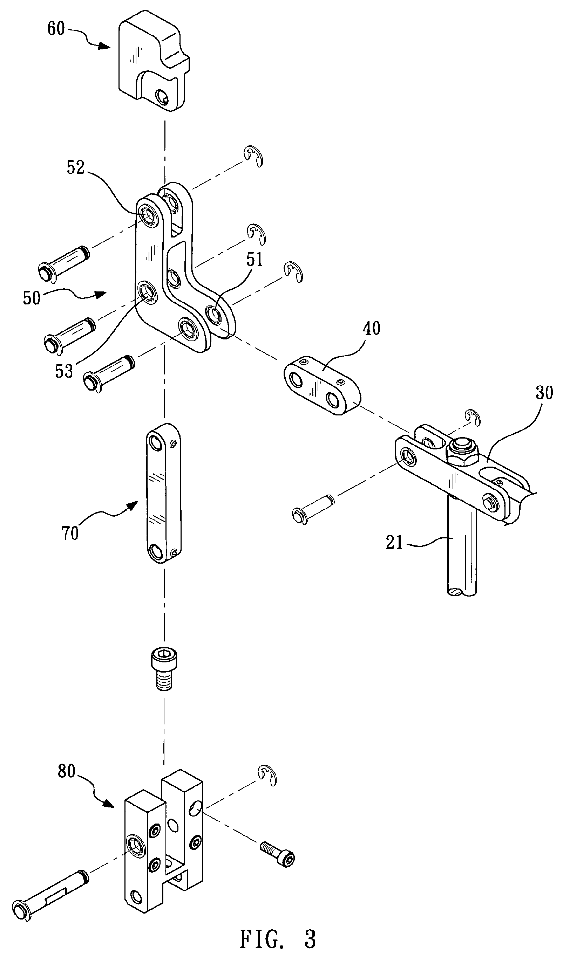

Referring to **FIGS. 1**-**4**, a self-lockable opening and closing mechanism for vacuum cabin door in accordance with the present invention is shown. As illustrated, the self-lockable opening and closing mechanism for vacuum cabin door comprises:
a frame **10** being a hollow member comprising a base portion **11,** two side panels **12** respectively perpendicularly connected to two opposite ends of the base portion **11** in parallel and a top panel **13** connected between respective distal ends of the two side panels **12** opposite to the base portion **11;**
a driving cylinder **20** prepared in the form of a pneumatic or hydraulic cylinder and mounted at the base portion **11** within the frame **10** and adapted to reciprocate a vertically extending driving shaft **21** thereof between a received position in the base portion **11** and an extended position toward the top panel **13;**
a horizontal lever **30** connected to the distal end of the driving shaft **21** at right angles;
at least one, for example, two first bars **40** each having one end thereof pivotally connected to one end of the horizontal lever **30;**
at least one, for example, two rotational levers **50** each comprising a first pivot hole **51,** a second pivot hole **52** and a third pivot hole **53** respectively disposed at three corners of a triangular profile thereof and having the first pivot hole **51** thereof pivotally connected to an opposite end of one respective first bar **40;**
at least one, for example, two adjustment blocks **60** respectively pivotally connected to the second pivot holes **52** of the two rotational levers **50;**
at least one, for example, two adjustment screws **61** rotatably mounted in the top panel **13** and respectively threaded into the two adjustment blocks **60** in a parallel manner relative to the axis of the driving shaft **21** and rotatable to adjust the distance between the respective adjustment block **60** and the top panel **13;**
at least one, for example, two second bars **70** each having one end thereof pivotally connected to the third pivot hole **53** of one respective rotational lever **50;**
at least one, for example, two sliding blocks **80** respectively slidably mounted one respective sliding guide means, for example, linear guideway **81** at each of the side panels **12** within the frame **10** in a parallel manner relative to axis of the driving shaft **21** and respectively pivotally connected to respective opposite ends of the second bars **70;** and
at least one, for example, two valve rods **90** each having one end thereof connected to one respective sliding block **80** and an opposite end thereof connected to a vacuum cabin door **100** for moving the vacuum cabin door **100** between an open position and a close position.

The aforesaid horizontal lever **30,** first bars **40,** rotational levers **50,** adjustment blocks **60,** second bars **70,** sliding blocks **80** and valve rods **90** form a linkage mechanism that is drivable by the driving shaft **21** of the driving cylinder **20** to move the vacuum cabin door **100** between the open position and the close position.

Further, the vacuum cabin door **100** comprises a door frame **101** and a door panel **102.** The door frame **101** is connected to one side of the base portion **11** of the frame **10** opposite to the driving cylinder **20,** defining therein a sliding groove **103** in parallel to the axis of the driving shaft **21** and an opening **104** cut through the sliding groove **103.** The valve rods **90** are inserted through the base portion **11** and connected to the door panel **102** so that the door panel **102** is movable by the valve rods **90** between the close position to seal the opening **104** and the open position to open the opening **104.**

When the rotational levers **50** and the second bars **70** are in the close position, the imaginary axis A extending through the second pivot hole **52** and third pivot hole **53** of each rotational lever **50** defines with the axis B of the respective second bar **70** a contained angle θ within the range of 170°∼190°. Preferably, when the rotational levers **50** and the second bars **70** are in the close position, the imaginary axis A extending through the second pivot hole **52** and third pivot hole **53** of each rotational lever **50** is in axial alignment with the axis B of the respective second bar **70** and in parallel to the axis of the driving cylinder **20.**

In the present preferred embodiment, one pair of first bars **40,** one pair of rotational levers **50,** one pair of adjustment blocks **60,** one pair of second bars **70,** one pair of sliding blocks **80** and one pair of valve rods **90** are provided and bilaterally arranged in a symmetric manner relative to the axis of the driving cylinder **20.**

After understanding the structural details of the self-lockable opening and closing mechanism for vacuum cabin door in accordance with the present invention, the operational principle of the present invention is outlined hereinafter:

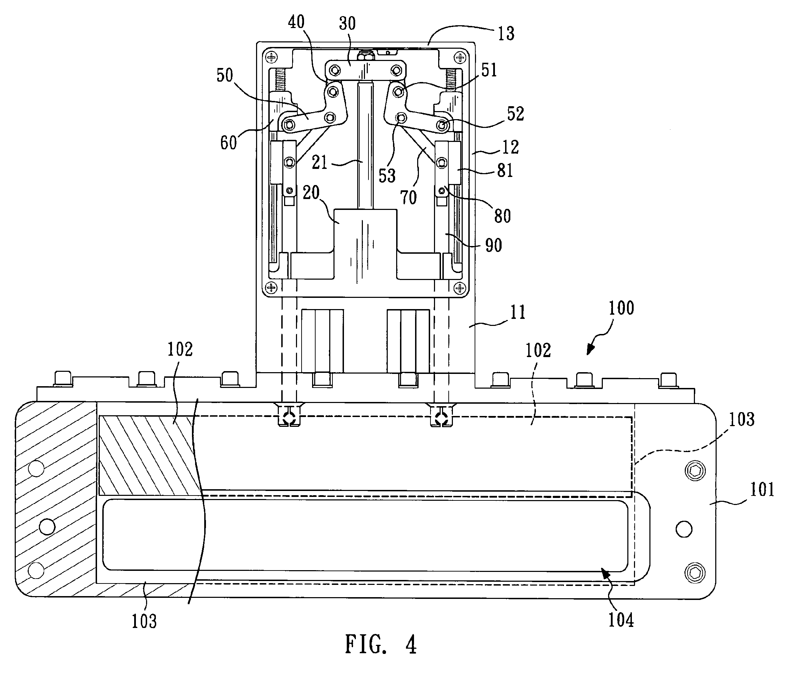

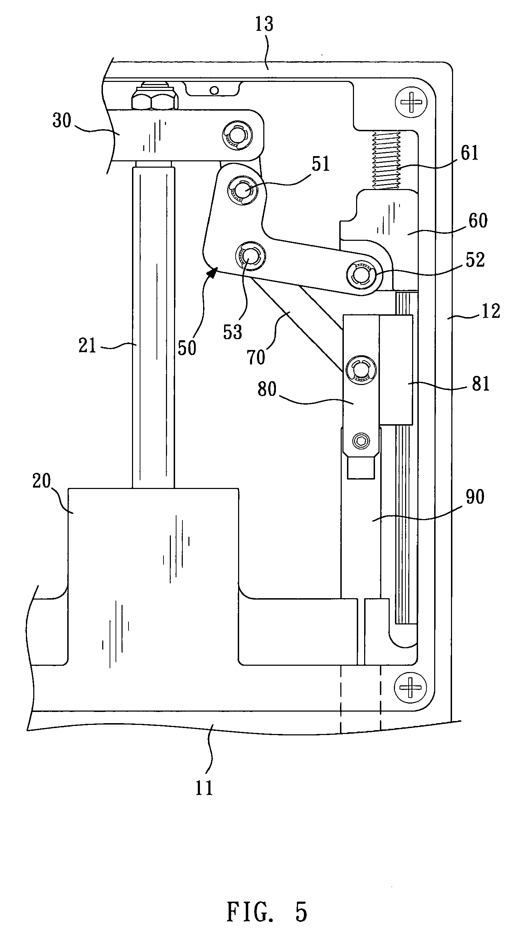

As shown in **FIG. 4** and **FIG. 5****,** when going to move the vacuum cabin door **100** to the open position, the driving shaft **21** of the driving cylinder **20** is extended out toward the top panel **13,** and the valve rods **90** moves the door panel **102** along the sliding grooves **103** toward the base portion **11** via the linking action of the horizontal lever **30,** first bars **40,** rotational levers **50,** adjustment blocks **60,** second bars **70** and sliding blocks **80,** thereby moving the door panel **102** to open the opening **104.**

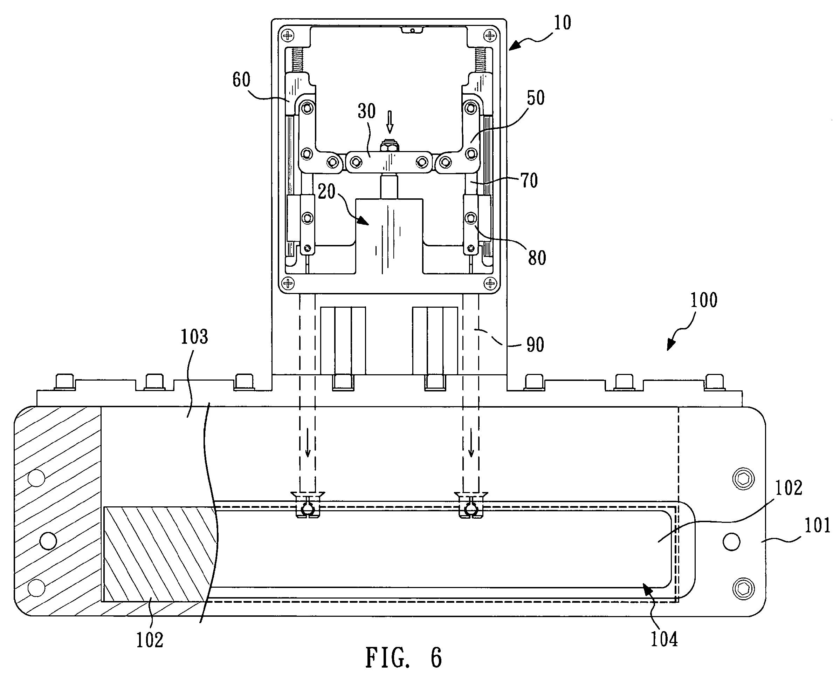

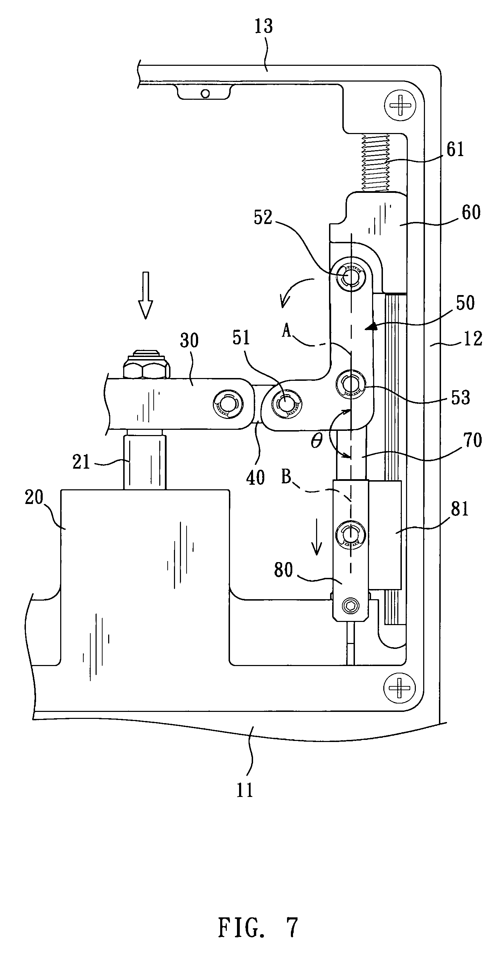

On the contrary, as shown in **FIG. 6** and **FIG. 7****,** when going to move the vacuum cabin door **100** to the close position, the driving shaft **21** of the driving cylinder **20** is retracted toward the inside of the base portion **11** to move the horizontal lever **30** and the first bars **40.** At this time, the first pivot hole **51** of each rotational lever **50** is driven by the respective first bar **40,** causing the respective rotational lever **50** to turn about the axis of the pivot point between the second pivot hole **52** of the respective rotational lever **50** and the associating adjustment block **60** and to further force the associating second bar **70** and the associating sliding block **80** along the respective sliding guide means **81** toward the base portion **11.** When each sliding block **80** is being moved toward the base portion **11,** the valve rods **90** are forced by the sliding blocks **80** toward the door frame **101,** thereby carrying the door panel **102** to seal the opening **104.**

When the driving cylinder **20** is driven to close the vacuum cabin door **100,** the contained angle θ defined between the imaginary axis A that extends through the second pivot hole **52** and third pivot hole **53** of each rotational lever **50** and the axis B of the respective second bar **70** is within the range of 170°∼190°. Further, when the rotational levers **50** and the second bars **70** are in the close position, the imaginary axis A extending through the second pivot hole **52** and third pivot hole **53** of each rotational lever **50** is in axial alignment with the axis B of the respective second bar **70** and in parallel to the axis of the driving cylinder 20. Thus, if the door panel **102** of the vacuum cabin door **100** is forced by a reaction force or any other factor to move in the reverse direction at this time, the reaction force will be linearly transferred through the valve rods **90,** the sliding blocks **80,** the second bars **70,** the rotational levers **50** and the adjustment blocks **60** to the top panel **13** of the frame **10,** preventing the component parts and the vacuum cabin door **100** from working and assuring positive locking of the vacuum cabin door **100.** Thus, the invention does not need an extra power to keep the driving cylinder **20** in the locking position. Even the driving cylinder **20** or the related piping leaks or lacks in strength, the vacuum cabin door **100** will neither become loose nor break the vacuum effect of the vacuum cabin.

Although one particular embodiment of the invention has been described in detail for purposes of illustration, various modifications and enhancements may be made without departing from the scope of the invention. Accordingly, the invention is not to be limited except as by the appended claims.

## Claims

1. A self-lockable opening and closing mechanism, comprising:
a frame (10) being a hollow frame formed of a base portion (11), two side panels (12) and a top panel (13);
a driving cylinder (20) mounted at said base portion (11) within said frame (10), said driving cylinder (20) comprising a reciprocatable driving shaft (21);
a horizontal lever (30) fixedly connected to said driving shaft (21);
a vacuum cabin door (100);
and at least one valve rod (90);
**characterised in that** the mechanism further comprises
at least one first bar (40) each having one end thereof pivotally connected to said horizontal lever (30);
at least one rotational lever (50) each comprising a first pivot hole (51), a second pivot hole (52) and a third pivot hole (53) respectively located at three corners of a triangular profile thereof, the first pivot hole (51) of each said rotational lever (50) being pivotally connected to an opposite end of one respective said first bar (40);
at least one adjustment block (60) respectively pivotally connected to the second pivot hole (52) of one respective said rotational lever (50);
at least one second bar (70) each having one end thereof pivotally connected to the third pivot hole (53) of one respective said rotational lever (50);
at least one sliding block (80) respectively slidably mounted at one respective said side panel (12) within said frame (10) and respectively pivotally connected to an opposite end of one respective said second bar (70); and
the at least one valve rod (90) each having one end thereof connected to one respective said sliding block (80) and an opposite end thereof connected to said vacuum cabin door (100) for moving said vacuum cabin door (100) between an open position and a close position.

2. The self-lockable opening and closing mechanism as claimed in claim 1, wherein said two side panels (12) of said frame (10) are respectively perpendicularly connected to two opposite ends of said base portion (11) in parallel; said top panel (13) of said frame (10) is connected between respective distal ends of said two side panels (12) opposite to said base portion (11).

3. The self-lockable opening and closing mechanism as claimed in claim 2, wherein said driving shaft (21) of said driving cylinder (2) is movable between a received position in said base portion (11) and an extended position toward said top panel (13).

4. The self-lockable opening and closing mechanism as claimed in claim 1, wherein when said at least one rotational lever (50) and said at least one second bar (70) are in said close position, the imaginary axis (A) extending through the second pivot hole (52) and third pivot hole (53) of each said rotational lever (50) and the axis (B) of the respective said second bar (70) define a contained angle (θ) within the range of 170°∼190°.

5. The self-lockable opening and closing mechanism as claimed in claim 1, wherein when said at least one rotational lever (50) and said at least one second bar (70) are in said close position, the imaginary axis (A) extending through the second pivot hole (52) and third pivot hole (53) of each said rotational lever (50) and the axis (B) of the respective said second bar (70) are kept in axial alignment and in a parallel relationship with the axis of said driving cylinder (20)

6. The self-lockable opening and closing mechanism as claimed in claim 1, further comprising at least one adjustment screw (61) rotatably mounted in said top panel (13) of said frame (10) and respectively threaded into one respective said adjustment block (60) in a parallel manner relative to the axis of said driving shaft (21) and rotatable to adjust the distance between one respective said adjustment block (60) and said top panel (13) of said frame (10).

7. The self-lockable opening and closing mechanism as claimed in claim 6, wherein each said adjustment screw (61) is mounted in said top panel (13) of said frame (10) to keep the axis thereof in parallel to the axis of said driving shaft (21).

8. The self-lockable opening and closing mechanism as claimed in claim 1, further comprising a sliding guide means (81) located at each said side panel (12) and extending in a parallel manner relative to the axis of said driving shaft (21) for guiding sliding movement of one respective said sliding block (80) along one respective said side panel (12) of said frame (10).

9. The self-lockable opening and closing mechanism as claimed in claim 8, wherein said sliding guide means (81) is a linear guideway.

10. The self-lockable opening and closing mechanism as claimed in claim 1, wherein said vacuum cabin door (100) comprises a door frame (101) and a door panel (102), said door frame (101) being connected to one side of said base portion (11) of said frame (10) opposite to said driving cylinder (20), said door frame (101) defining therein a sliding groove (103) in parallel to the axis (B) of said driving shaft (21) and an opening (104) cut through said sliding groove (103); said at least one valve rod (90) is connected with said door panel (102) and reciprocatable to move said door panel (102) between said close position to seal said opening (104) and said open position to open said opening (104).

## Patentansprüche

1. Ein selbstvernegelbarer Öffnungs- und Schließmechanismus, umfassend:
einen Rahmen (10), welcher ein aus einem Basisabschnitt (11), zwei Seitenplatten (12) und einer Oberseitenplatte (13) ausgebildeter Hohlrahmen ist;
einen Antriebszylinder (20), der in dem Rahmen (10) an dem Basisabschnitt (11) angebracht ist, wobei der Antriebszylinder (20) eine umkehrbare Antriebswelle (21) umfasst;
einen horizontalen Arm (30), der fest mit der Antriebswelle (21) verbunden ist;
eine Vakuumkabinentür (100); und
mindestens ein Ventilschaft (90);
**dadurch gekennzeichnet, dass** der Mechanismus ferner umfasst
mindestens einen ersten Stab (40), der jeweils ein Ende aufweist, das schwenkbar mit dem horizontalen Arm (30) verbunden ist;
mindestens einen Rotationsarm (50), der jeweils ein erstes Schwenkloch (51), ein zweites Schwenkloch (52) und ein drittes Schwenkloch (53) aufweist, die jeweils an drei Ecken eines dreieckigen Profils des Armes angeordnet sind, wobei das erste Schwenkloch (51) jedes Rotationsarms (50) schwenkbar mit einem gegenüberliegenden Ende eines jeweiligen ersten Stabes (40) verbunden ist;
mindestens einen Einstellblock (60), der jeweils schwenkbar mit dem zweiten Schwenkloch (52) eines jeweiligen Rotationsarms (50) verbunden ist;
mindestens einen zweiten Stab (70), der jeweils ein Ende aufweist, das schwenkbar mit dem dritten Schwenkloch (53) eines jeweiligen Rotationsarmes (50) verbunden ist;
mindestens einen Gleitblock (80), der jeweils verschiebbar an einer jeweiligen Seitenplatte (12) in dem Rahmen (10) angebracht und jeweils schwenkbar mit einem gegenüberliegenden Ende eines jeweiligen zweiten Stabes (70) verbunden ist; und
den mindestens einen Ventilschaft (90), der jeweils mindestens ein Ende aufweist, das mit einem jeweiligen Gleitblock (80) verbunden ist, und ein gegenüberliegendes Ende, das mit der Vakuumkabinentür (100) verbunden ist, um die Vakuumkabinentür (100) zwischen einer Offen-Position und einer Geschlossen-Position zu bewegen.

2. Der selbstverriegelbare Öffnungs- und Schließmechanismus gemäß Anspruch 1, wobei die zwei Seitenplatten (12) des Rahmens (10) parallel zueinander und jeweils senkrecht mit zwei gegenüberliegenden Enden des Basisabschnitts (11) verbunden sind; die Oberseitenplatte (13) des Rahmens (10) dem Basisabschnitt (11) gegenüberliegend zwischen jeweiligen distalen Enden der zwei Seitenplatten (12) verbunden ist.

3. Der selbstverriegelbare Öffnungs- und Schließmechanismus gemäß Anspruch 2, wobei die Antriebswelle (21) des Antriebszylinders (2) zwischen einer Aufgenommen-Position in dem Basisabschnitt (11) und einer Ausgefahren-Position zu der Oberseitenplatte (13) hin bewegbar ist.

4. Der selbstverriegelbare Öffnungs- und Schließmechanismus gemäß Anspruch 1, wobei, wenn der mindestens eine Rotationsarm (50) und der mindestens eine zweite Stab (70) in der Geschlossen-Position sind, die imaginäre Achse (A), die sich durch das zweite Schwenkloch (52) und das dritte Schwenkloch (53) jedes Rotationsarms (50) erstreckt, und die Achse (B) des jeweiligen zweiten Stabes (70) einen eingeschlossenen Winkel (θ) in einem Bereich von 170° - 190° definieren.

5. Der selbstverriegelbare Öffnungs- und Schließmechanismus gemäß Anspruch 1, wobei, wenn der mindestens eine Rotationsarm (50) und der mindestens eine zweite Stab (70) in der Geschlossen-Position sind, die imaginäre Achse (A), die sich durch das zweite Schwenkloch (52) und das dritte Schwenkloch (53) jedes der Rotationsarme (50) erstreckt, und die Achse (B) des jeweiligen zweiten Stabes (70) in axialer Flucht und parallel zu der Achse des Antriebszylinders (20) gehalten werden.

6. Der selbstverriegelbare Öffnungs- und Schließmechanismus gemäß Anspruch 1, ferner umfassend mindestens eine Einstellschraube (61), welche drehbar in der Oberseitenplatte (13) des Rahmens (10) montiert ist und jeweils in paralleler Weise relativ zu der Achse der Antriebswelle (21) in den jeweiligen Einstellblock (60) geschraubt ist und drehbar ist, um den Abstand zwischen einem jeweiligen Einstellblock (60) und der Oberseitenplatte (13) des Rahmens (10) einzustellen.

7. Der selbstverriegelbare Öffnungs- und Schließmechanismus gemäß Anspruch 6, wobei jede Einstellschraube (61) in der Oberseitenplatte (13) des Rahmens (10) montiert ist, um ihre Achse parallel zu der Achse der Antriebswelle (21) zu halten.

8. Der selbstverriegelbare Öffnungs- und Schließmechanismus gemäß Anspruch 1, ferner umfassend ein Gleitführungsmittel (81), das an jeder Seitenplatte (12) angeordnet ist und sich in paralleler Weise relativ zu der Achse der Antriebswelle (21) zum Führen einer Gleitbewegung eines jeweiligen Gleitblocks (80) entlang einer jeweiligen Seitenplatte (12) des Rahmens (10) erstreckt.

9. Der selbstverriegelbare Öffnungs- und Schließmechanismus gemäß Anspruch 8, wobei das Gleitführungsmittel (81) eine lineare Führungsschiene ist.

10. Der selbstverriegelbare Öffnungs- und Schließmechanismus gemäß Anspruch 1, wobei die Vakuumkabinentür (100) einen Türrahmen (101) und ein Türblatt (102) aufweist, wobei der Türrahmen (101) mit einer Seite des Basisabschnitts (11) des Rahmens (10) gegenüberliegend des Antriebszylinders (20) verbunden ist, wobei der Türrahmen darin eine Gleitnut (103) parallel zu der Achse (B) der Antriebswelle (21) definiert und eine Öffnung (104) durch die Gleitnut (103) geschnitten ist; wobei der mindestens eine Ventilschaft (90) mit dem Türblatt (102) verbunden ist und umkehrbar ist, um das Türblatt (102) zwischen der Geschlossen-Position zum Verschließen der Öffnung (104) und der Offen-Position zum Öffnen der Öffnung (104) zu bewegen.

## Revendications

1. - Mécanisme d'ouverture et de fermeture auto-verrouillable comprenant :
un cadre (10) qui est un cadre creux formé d'une partie de base (11), de deux panneaux latéraux (12) et d'un panneau supérieur (13) ;
un cylindre d'entraînement (20) monté à ladite partie de base (11) à l'intérieur dudit cadre (10), ledit cylindre d'entraînement (20) comprenant un arbre d'entraînement alternatif (21) ;
un levier horizontal (30) relié de façon fixe audit arbre d'entraînement (21) ;
une porte de cabine à vide (100) ; et
au moins une tige de soupape (90) ;
**caractérisé par le fait que** le mécanisme comprend en outre :
au moins une première barre (40) ayant chacune une extrémité de celle-ci reliée de façon pivotante audit levier horizontal (30) ;
au moins un levier rotatif (50) chacun comprenant un premier trou de pivotement (51), un deuxième trou de pivotement (52) et un troisième trou de pivotement (53) situés respectivement à trois coins d'un profil triangulaire de celui-ci, le premier trou de pivotement (51) de chaque levier rotatif précité (50) étant relié de façon pivotante à une extrémité opposée de ladite première barre respective (40) ;
au moins un bloc d'ajustement (60) respectivement relié de façon pivotante au deuxième trou de pivotement (52) d'un levier rotatif respectif précité (50) ;
au moins une seconde barre (70) ayant chacune une extrémité de celle-ci reliée de façon pivotante au troisième trou de pivotement (53) d'un levier rotatif respectif précité (50) ;
au moins un bloc coulissant (80) respectivement monté de façon coulissante à un panneau latéral respectif précité (12) à l'intérieur dudit cadre (10) et respectivement relié de façon pivotante à une extrémité opposée d'une seconde barre respective précitée (70) ; et
l'au moins une tige de soupape (90) chacune ayant une extrémité de celle-ci reliée à un bloc coulissant respectif précité (80) et une extrémité opposée de celle-ci reliée à ladite porte de cabine à vide (100) pour déplacer ladite porte de cabine à vide (100) entre une position ouverte et une position fermée.

2. - Mécanisme d'ouverture et de fermeture auto-verrouillable selon la revendication 1, dans lequel lesdits deux panneaux latéraux (12) dudit cadre (10) sont respectivement reliés perpendiculairement à deux extrémités opposées de ladite partie de base (11) en parallèle ; ledit panneau supérieur (13) dudit cadre (10) est relié entre des extrémités distales respectives desdits deux panneaux latéraux (12) à l'opposé de ladite partie de base (11).

3. - Mécanisme d'ouverture et de fermeture auto-verrouillable selon la revendication 2, dans lequel ledit arbre d'entraînement (21) dudit cylindre d'entraînement (2) est mobile entre une position reçue dans ladite partie de base (11) et une position étendue vers ledit panneau supérieur (13).

4. - Mécanisme d'ouverture et de fermeture auto-verrouillable selon la revendication 1, dans lequel, lorsque ledit au moins un levier rotatif (50) et ladite au moins une seconde barre (70) sont dans ladite position fermée, l'axe imaginaire (A) s'étendant à travers le deuxième trou de pivotement (52) et le troisième trou de pivotement (53) de chaque levier rotatif précité (50) et l'axe (B) de ladite seconde barre respective (70) définissent un angle contenu (θ) se situant dans la plage de 170°∼190°.

5. - Mécanisme d'ouverture et de fermeture auto-verrouillable selon la revendication 1, dans lequel, lorsque ledit au moins un levier rotatif (50) et ladite au moins une seconde barre (70) sont dans ladite position fermée, l'axe imaginaire (A) s'étendant à travers le deuxième trou de pivotement (52) et le troisième trou de pivotement (53) de chaque levier rotatif précité (50) et l'axe (B) de ladite seconde barre respective (70) sont maintenus en alignement axial et dans une relation parallèle avec l'axe dudit cylindre d'entraînement (20).

6. - Mécanisme d'ouverture et de fermeture auto-verrouillable selon la revendication 1, comprenant en outre au moins une vis d'ajustement (61) montée de façon rotative dans ledit panneau supérieur (13) dudit cadre (10) et respectivement visée dans un bloc d'ajustement respectif précité (60) d'une manière parallèle par rapport à l'axe dudit arbre d'entraînement (21) et apte à tourner pour ajuster la distance entre un bloc d'ajustement respectif précité (60) et ledit panneau supérieur (13) dudit cadre (10).

7. - Mécanisme d'ouverture et de fermeture auto-verrouillable selon la revendication 6, dans lequel chaque vis d'ajustement précitée (61) est montée dans ledit panneau supérieur (13) dudit cadre (10) pour maintenir l'axe de celle-ci en parallèle à l'axe dudit arbre d'entraînement (21).

8. - Mécanisme d'ouverture et de fermeture auto-verrouillable selon la revendication 1, comprenant en outre un moyen de guidage de coulissement (81) situé à chaque panneau latéral précité (12) et s'étendant d'une manière parallèle par rapport à l'axe dudit arbre d'entraînement (21) pour guider le mouvement de coulissement d'un bloc coulissant respectif précité (80) le long d'un panneau latéral respectif précité (12) dudit cadre (10).

9. - Mécanisme d'ouverture et de fermeture auto-verrouillable selon la revendication 8, dans lequel ledit moyen de guidage de coulissement (81) est un passage de guidage linéaire.

10. - Mécanisme d'ouverture et de fermeture auto-verrouillable selon la revendication 1, dans lequel ladite porte de cabine à vide (100) comprend un cadre de porte (101) et un panneau de porte (102), ledit cadre de porte (101) étant relié à un côté de ladite partie de base (11) dudit cadre (10) à l'opposé dudit cylindre d'entraînement (20), ledit cadre de porte (101) définissant dans celui-ci une rainure de coulissement (103) en parallèle à l'axe (B) dudit arbre d'entraînement (21) et une ouverture (104) coupée à travers ladite rainure de coulissement (103) ; ladite au moins une tige de soupape (90) est reliée audit panneau de porte (102) et de manière alternative pour déplacer ledit panneau de porte (102) entre ladite position fermée pour sceller de manière étanche ladite ouverture (104) et ladite position ouverte pour ouvrir ladite ouverture (104).
